# FASCICULE DE BREVET EUROPEEN

(11) **EP 0 823 727 B1**
(45) Date de publication et mention de la délivrance du brevet: **02.06.1999**
(21) Numéro de dépôt: 97460025.6
(22) Date de dépôt: 02.07.1997
(51) Int. Cl.: H01L 21/331

(54) **Procédé de fabrication de la base extrinsèque d'un transistor NPN dans une technologie bipolaire haute fréquence**
Verfahren zur Herstellung des extrinsischen Basisbereichs eines NPN-Transistors mit einer bipolaren Hochfrequenztechnologie
Process for making the extrinsic base of a NPN transistor in a bipolar high frequency technology

(30) Priorité: 10.07.1996 FR 9608832
(43) Date de publication de la demande: 11.02.1998
(73) Titulaire: STMicroelectronics S.A., 94250 Gentilly (FR)
(72) Inventeur: Loheac, Jean-Luc, 56100 Lorient (FR)
(74) Mandataire: Schmit, Christian Norbert Marie

(56) Documents cités:
- EP-A- 0 139 130
- WO-A-96/10839
- US-A- 5 489 541
- CHANTRE A ET AL: "IDENTIFICATION OF A CORNER TUNNELING CURRENT COMPONENT IN ADVANCED CMOS-COMPATIBLE BIPOLAR TRANSISTORS" IEEE TRANSACTIONS ON ELECTRON DEVICES, vol. 38, no. 1, 1 janvier 1991, pages 107-110, XP000160917
- TZE-CHIANG CHEN ET AL: "AN ADVANCED BIPOLAR TRANSISTOR WITH SELF-ALIGNED ION-IMPLANTED BASE AND W/POLY EMITTER" IEEE TRANSACTIONS ON ELECTRON DEVICES, vol. 35, no. 8, août 1988, pages 1322-1327, XP000030550

## Description

La présente invention concerne la fabrication de circuits intégrés bipolaires haute fréquence, et plus particulièrement la fabrication de la base extrinsèque d'un transistor NPN dans une technologie bipolaire haute fréquence.

Un tel procédé de fabrication regroupe l'ensemble des étapes à effectuer pour réaliser un circuit intégré à partir d'une plaquette de silicium. Ainsi, le procédé comprend des étapes de dopage par implantation ionique ou par prédépôt, de photolithographie, d'oxydation thermique, de croissance épitaxiale, de diffusion et de gravure plasma ou chimique.

Ces procédés de fabrication sont constamment améliorés pour augmenter la densité d'intégration des circuits intégrés ainsi que leurs performances électriques.

Un procédé de fabrication classique connu, décrivant principalement les étapes pour réaliser un transistor NPN, est décrit ci-après. N'y figurent pas cependant toutes les étapes de nettoyage qui n'ont aucun effet sur la structure des couches mais qui sont essentielles pour obtenir de bons rendements de fabrication.

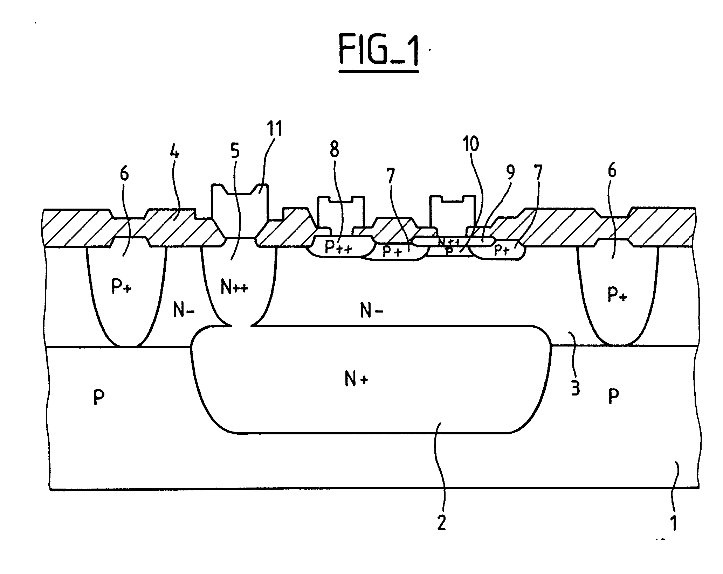

La figure 1 représentant une vue en coupe d'un transistor NPN, est jointe à titre indicatif pour repérer les différentes zones et couches d'un transistor NPN réalisé dans une technologie bipolaire haute fréquence. Le matériau de départ est un substrat semiconducteur de type P. Le procédé comprend les étapes suivantes:
a) Dopage par implantation ionique du substrat 1 pour former une couche enterrée 2 de type N très dopée;
b) Croissance épitaxiale d'une couche 3 de type N faiblement dopée;
c) Oxydation post-épitaxiale pour former un film mince d'oxyde à la surface de la couche épitaxiale suivi du dépôt d'un film de nitrure de silicium; le film d'oxyde permet d'éviter le stress tensile provoqué par le film de nitrure sur la couche épitaxiale et est également utilisé comme oxyde tampon lors d'une implantation ionique; ces deux films n'apparaissent pas sur la figure 1 car ils sont retirés en fin de procédé;
d) Isolation par oxyde latéral 4 appelé également croissance LOCOS épais pour isoler les composants les uns des autres;
e) Création d'un puits collecteur 5 fortement dopé de type N par implantation ionique;
f) Isolation par diffusion anticanal, c'est-à-dire création d'un canal 6 de type P sous l'oxyde épais 4 par implantation ionique pour éviter des courants de fuite entre collecteurs, puis diffusion de ces canaux dans la couche épitaxiale 3; la diffusion du puits collecteur est effectuée simultanément;
g) Définition de zones dites actives dans la couche épitaxiale 3 par gravure de la couche de nitrure de silicium;
h) Création d'une base extrinsèque 7 par prédépot de bore à partir de nitrure de bore; la base extrinsèque 7 est une zone active du transistor NPN qui fait la liaison entre une base intrinsèque 10 située sous une zone émetteur 9 et une zone de contact de base 8 reliant la base intrinsèque 10 à une première couche métallique; la base extrinsèque 7 est fortement dopée afin de diminuer la résistance rbb' du schéma de giacoletto et permettre au circuit intégré de fonctionner à haute fréquence; l'opération de prédépôt est bien entendu suivie d'une étape de diffusion du bore dans la couche épitaxiale; l'étape h) sera plus particulièrement décrite dans la suite de la description;
i) création par implantation ionique de la zone de contact de base 8 de type P; cette zone est fortement dopée pour obtenir un bon contact ohmique entre la première couche métallique et le reste de la base;
j) Création de la zone émetteur 9 de type N fortement dopée par implantation ionique;
k) Création de la base intrinsèque 10 dopée P par implantation ionique;
l) Création de résistances par implantation ionique; consécutivement à ces quatre implantations ioniques, on effectue une diffusion des dopants dans la couche épitaxiale;
m) Dépôt de couches métalliques 11; ces couches permettent la connexion des composants du circuit intégré entre eux;
n) Dépôt d'une couche de passivation pour protéger le circuit intégré;

On constate, en considérant les différentes étapes de ce procédé de fabrication, que les opérations de dopage sont effectuées soit par prédépôt, soit par implantation ionique. La technique du prédépôt est la technique de dopage la plus ancienne et permet une introduction contrôlée des dopants dans le substrat. Cependant, l'implantation ionique offre un contrôle encore plus précis de la dose et de la profondeur de pénétration des dopants implantés dans le substrat.

Néanmoins, une étape de prédépôt subsiste pour réaliser la base extrinsèque des transistors NPN. En effet, la base extrinsèque est une zone active du transistor NPN et, à ce titre, ne supporte qu'un très faible taux de défauts dans sa structure. Or, lorsque le substrat ou la couche épitaxiale est soumis à une implantation ionique, le réseau cristallin subit des dommages dus aux collisions atomiques et devient amorphe. Les défauts du réseau cristallin sont ensuite bien souvent amplifiés lors de l'oxydation qui suit l'étape de diffusion des dopants de la base extrinsèque.

Ces défauts peuvent alors entraîner des problèmes électriques, en particulier des problèmes au niveau des tensions de claquage base-émetteur et base-collecteur du transistor NPN.

L'étape de réalisation de la base extrinsèque (étape h) est donc généralement effectuée par prédépôt pour éviter ces problèmes électriques. Cette étape comprend les opérations suivantes:
- une croissance d'oxyde LOCOS mince pour protéger les zones actives de l'ensemble des composants de la plaquette; ces zones actives sont par exemple la base extrinsèque d'un transistor NPN, la base d'un transistor PNP ou les zones prévues pour des résistances implanteés;
- une photogravure pour enlever l'oxyde LOCOS mince sur les zones de base extrinsèque des transistors NPN; en effet, le dopage par prédépôt de bore ne concerne que la base extrinsèque du transistor NPN;
- un prédépôt de bore à partir de plaquettes de nitrure de bore sur l'ensemble de la plaquette; lors du prédépôt, une couche d'oxyde et une couche de verre de bore se forment à la surface de la couche dopée; une première attaque à l'acide fluorhydrique permet de supprimer la couche d'oxyde; une opération de dilution fait ensuite croître une nouvelle couche d'oxyde qui vient absorber le verre de bore; une seconde attaque à l'acide fluorhydrique vient supprimer cette seconde couche d'oxyde;
- une diffusion des dopants dans le silicium suivie d'une seconde croissance d'oxyde LOCOS mince en surface de la zone dopée.

Cette étape de réalisation de la base extrinsèque du transistor NPN (étape h) nécessite de nombreux passages des plaquettes en four conventionnel (croissances d'oxyde, prédépot, dilution, diffusion) ainsi que plusieurs opérations de nettoyage et de gravure chimique (attaques à l'acide fluorhydrique), et est par conséquent très longue.

Un but de l'invention est d'alléger cette étape de fabrication de la base extrinsèque d'un transistor NPN sans pour autant avoir à remanier les autres étapes du procédé de fabrication du transistor NPN, et en visant un résultat au moins équivalent au vu de la technique classique.

A cet effet, conformément à l'invention, il est mis en oeuvre un procédé de fabrication de la base extrinsèque d'un transistor NPN dans une technologie bipolaire haute fréquence comportant les étapes successives suivantes: détermination par photogravure, d'une zone réservée à la base extrinsèque sur une couche épitaxiale et introduction de dopants dans ladite zone par implantation ionique comme cela est connu de A. Chantre et al., IEEE Transactions on Electron Devices 38 (1), 107 (1991).

Plus précisément, l'invention a pour objet un procédé de fabrication de la base extrinsèque d'un transistor NPN dans une technologie bipolaire haute fréquence, comportant les étapes successives suivantes:
- détermination par photogravure d'une zone réservée à la base extrinsèque sur une couche épitaxiale;
- introduction de dopants dans ladite zone par implantation ionique;
- réalisation d'un premier recuit thermique très rapide pour recristalliser ladite zone implantée et pour que les dopants ne diffusent pas dans la couche épitaxiale; et
- réalisation d'un second recuit thermique dans un four conventionnel pour la diffusion des dopants dans la couche épitaxiale suivi d'une oxydation en surface de ladite zone.

La température et le temps du premier recuit thermique sont choisis pour éviter toute diffusion des dopants dans la couche épitaxiale.

Le premier recuit thermique est réalisé par montée très rapide à une température comprise entre 1100°C et 1200°C, environ, et maintien à cette température pendant une durée inférieure à 30 secondes.

De préférence, le maintien à une température comprise entre 1100°C et 1200°C est inférieur à 15 secondes.

Contrairement au second recuit thermique effectué dans un four conventionnel dans lequel on peut traiter simultanément un nombre important de plaquettes de circuit intégré, le premier recuit thermique est réalisé dans un four de plus petite dimension permettant de monter plus rapidement et plus haut en température.

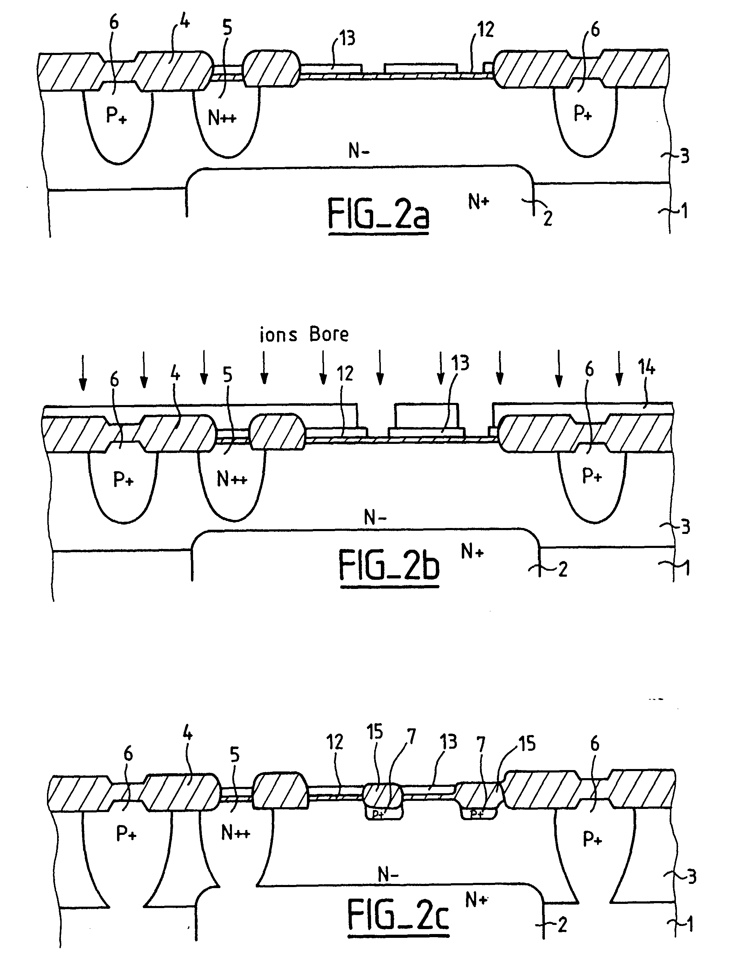

D'autres caractéristiques et avantages de l'invention apparaîtront à la lecture de la description qui suit et qui est faite en référence aux dessins annexés dans lesquels, outre la figure 1 déjà décrite, les figures 2a à 2c sont des vues en coupe schématiques représentant divers états en cours de fabrication de la base extrinsèque d'un transistor selon l'invention.

La figure 2a représente une vue en coupe schématique d'un état correspondant à la fin de l'étape g).

A ce stade du procédé, le transistor comporte, dans un substrat 1 de type P, une couche enterrée 2 très dopée de type N sur laquelle on a fait croître une couche épitaxiale 3 peu dopé de type N. Une couche d'oxyde épais 4 recouvre en partie la surface de la couche épitaxiale 3. Cette couche d'oxyde épais 4 peut être, par exemple, obtenue par chauffage de la plaquette dans un four conventionnel en présence de vapeur. Des zones de diffusion anticanal 6 sous l'oxyde épais 4 permettent d'isoler le transistor des autres composants de la plaquette. Le transistor comporte également un puits collecteur 5 qui est une zone fortement dopée de type N située dans la couche épitaxiale 3.

Par ailleurs, un film mince d'oxyde 12 ainsi qu'une couche de nitrure de silicium 13 recouvrent la couche épitaxiale 3 entre les zones d'oxyde épais 4. Au cours de l'étape g), la couche de nitrure 13 est partiellement ôtée pour permettre l'accès et/ou la définition desdites zones actives du transistor.

Les figures 2b et 2c sont des vues en coupe schématiques représentant plus particulièrement les états en cours de fabrication de la base extrinsèque d'un transistor selon l'invention.

Le procédé comporte tout d'abord une étape de photogravure et une étape de dopage illustrées à la figure 2b. Au cours de cette étape, une couche de résine photosensible 14 est déposée sur la surface supérieure de la plaquette. Cette couche est ensuite exposée à un rayonnement ultraviolet à travers un masque pour irradier la résine recouvrant la zone réservée à la base extrinsèque du transistor. La résine irradiée dont la structure a été modifiée par le rayonnement, est ensuite enlevée. Le masque utilisé pour cette étape est le masque employé dans le procédé de l'état de la technique pour la photogravure de l'oxyde LOCOS mince. Le procédé selon l'invention ne nécessite donc pas de masque supplémentaire.

Suit une étape de dopage par implantation ionique pendant laquelle la plaquette est soumise à un faisceau d'ions bore pour doper à travers l'oxyde 12 la zone réservée à la base extrinsèque du transistor NPN.

En pratique, le dopage de la base extrinsèque nécessite l'implantation de 3.10¹⁵ ions bore (B) par centimètre carré avec une énergie d'implantation de 15 kev environ. Pour une implantation d'ions BF2 (bifluorine de bore), l'énergie nécessaire est de 55 kev environ.

La plaquette subit ensuite un premier recuit thermique très rapide entraînant une recristallisation au moins partielle de la zone implantée. Cette recristallisation n'est pas visible sur le schéma de la figure 2b car elle est effectuée suffisamment rapidement pour que les dopants ne se diffusent pas dans la couche épitaxiale 3. Cette étape est primordiale dans le procédé selon l'invention.

Le premier recuit thermique rapide est effectué dans un four de type RTA (Rapid Thermal Annealing) permettant de monter très rapidement et très haut en température. Pour recristalliser la zone implantée, la température maximale de recuit thermique est fixée entre 1100°C et 1200°C, cette température étant maintenue pendant une durée inférieure à trente secondes. En pratique, les plaquettes de circuit intégré sont traitées individuellement dans le four RTA. Le temps et la température de recuit sont fonction de la dose et de l'énergie de l'implantation ionique.

De préférence, cette durée est inférieure à quinze secondes pour éviter tout risque de diffusion avant recristallisation.

La plaquette subit ensuite un second recuit thermique pour permettre la diffusion des dopants implantés dans la couche épitaxiale 3. Au cours de cette étape, illustrée à la figure 2c, les dopants du puits collecteur 5 et des zones de diffusion anticanal 6 diffusent également dans la couche épitaxiale 3 pour atteindre respectivement la couche enterrée 2 et le substrat 1.

Cette étape est suivie d'une étape d'oxydation dans laquelle on fait croître un oxyde LOCOS mince 15 en surface des zones nouvellement implantées.

Par ce procédé, toutes les jonctions électriques des transistors NPN sont réalisées, dans la technologie concernée, par implantation ionique. De ce fait, de par les avantages de l'implantation ionique, cela permet d'obtenir un meilleur contrôle des gains en courant des transistors NPN. Dès lors, une augmentation du diamètre des plaquettes de silicium sur lesquelles sont réalisés les circuits intégrés, est réalisable.

Par ailleurs, l'ensemble des étapes de fabrication de la base extrinsèque d'un transistor NPN a été étudié pour ne pas avoir à remanier les autres étapes du procédé de fabrication d'un transistor NPN. A cet effet, l'étape de diffusion des dopants de la base extrinsèque du procédé selon l'invention n'a pas été modifiée pour ne pas changer la profondeur de diffusion de l'ensemble des zones dopées du transistor.

Le procédé selon l'invention permet de supprimer une étape de croissance d'oxyde LOCOS mince. La suppression de cette étape peut se révéler un avantage pour la réalisation de transistors NPN à émetteur lavé. Un transistor à émetteur lavé est un transistor NPN classique dont la taille de la zone émetteur est réduite. De ce fait, son gain en courant est plus faible que le gain en courant d'un transistor classique.

Ce type de transistor n'est pas toujours réalisable dans certaines technologies, en particulier les technologies obtenues par réduction des règles de dessin d'une technologie mère.

Lors d'une croissance d'oxyde, la couche d'oxyde croît verticalement et horizontalement. Dans le procédé par prédépôt, il y a deux croissances d'oxyde LOCOS mince à la surface de la base extrinsèque qui ont tendance à diminuer la surface d'implantation de la zone d'émetteur 9.

Par conséquent, la suppression d'une étape de croissance LOCOS mince augmente la surface d'implantation de l'émetteur des transistors NPN et de ce fait augmente leur gain en courant, notamment celui du transistor à contact émetteur lavé. L'augmentation du gain en courant de ce transistor permet d'envisager une réduction optique des règles de dessin pour tous les types de circuit intégré de la technologie concernée.

Par ailleurs, une analyse d'une coupe transversale d'une plaquette de circuit intégré par révélation chimique des zones de dopage et des interfaces silicium-oxyde permet de contaster la disparition des extrémités en forme de "tête d'oiseau" de la couche d'oxyde LOCOS mince. Ce motif de "tête d'oiseau" est typique des procédés comportant deux étapes d'oxydation LOCOS mince. Cette absence de motif est entièrement due à la suppression d'une étape d'oxydation LOCOS mince dans le procédé de fabrication du transistor. Cette analyse peut être effectuée avec un microscope électronique à balayage (MEB).

Bien que l'on ait décrit un procédé concernant la fabrication de la base extrinsèque d'un transistor NPN, ce procédé pourra être adapté pour la fabrication de toute autre zone active d'un circuit intégré.

## Revendications

1. Procédé de fabrication de la base extrinsèque d'un transistor NPN dans une technologie bipolaire haute fréquence, comportant les étapes successives suivantes:
- détermination par photogravure d'une zone réservée à la base extrinsèque sur une couche épitaxiale;
- introduction de dopants dans ladite zone par implantation ionique;
- réalisation d'un premier recuit thermique très rapide pour recristalliser ladite zone implantée et pour que les dopants ne diffusent pas dans la couche épitaxiale; et
- réalisation d'un second recuit thermique dans un four conventionnel pour la diffusion des dopants dans la couche épitaxiale suivi d'une oxydation en surface de ladite zone.

2. Procédé selon la revendication 1, caractérisé en ce que le premier recuit thermique est réalisé par montée très rapide à une température comprise entre 1100°C et 1200°C, environ, et maintien à cette température pendant une durée inférieure à 30 secondes.

3. Procédé selon la revendication 2, caractérisé en ce que le maintien à une température comprise entre 1100°C et 1200°C est inférieur à 15 secondes.

## Patentansprüche

1. Verfahren zum Herstellen der extrinsischen Basis eines NPN-Transistors in einer Bipolar-Hochfrequenztechnik, das die folgenden Schritte, die aufeinander folgen, umfaßt:
- Festlegen eines reservierten Bereiches für die extrinsische Basis auf einer epitaxialen Schicht durch Photoätzen,
- Einbauen von Dotierstoffen in dem Bereich durch Ionenimplantation,
- Durchführen eines ersten, sehr schnellen thermischen Aufheizens zum Rekristallisieren des implantierten Bereiches und so, daß die Dotierstoffe nicht in die epitaxiale Schicht diffundieren, und
- Durchführen eines zweiten thermischen Aufheizens in einem konventionellen Ofen für die Diffusion von Dotierstoffen in der epitaxialen Schicht, gefolgt von einer Oxidation der Oberfläche des Bereiches.

2. Verfahren nach Anspruch 1, dadurch gekennzeichnet, daß das erste thermische Aufheizen als sehr schnelles Ansteigen auf eine Temperatur zwischen etwa 1100 und 1200 °C und Halten auf dieser Temperatur während einer Dauer von weniger als 30 s durchgeführt wird.

3. Verfahren nach Anspruch 2, dadurch gekennzeichnet, daß das Halten auf einer Temperatur zwischen 1100 und 1200 °C weniger als 15 s andauert.

## Claims

1. Method of manufacturing the extrinsic base of an npn transistor in a high-frequency bipolar technology, including the following successive steps:
- determining, by photogravure, a region reserved for the extrinsic base on an epitaxial layer;
- introducing dopants into the said region by ionic implantation;
- effecting a first very rapid heat annealing in order to recrystallise the said implanted region and so that the dopants do not diffuse in the epitaxial layer; and
- effecting a second heat annealing in a conventional oven for diffusing the dopants in the epitaxial layer followed by a surface oxidation of the said region.

2. Method according to Claim 1, characterised in that the first heat annealing is carried out by means of a very rapid rise to a temperature of between 1100°C and 1200°C, approximately, and maintaining at this temperature for a period of less than 30 seconds.

3. Method according to Claim 2, characterised in that the maintaining at a temperature of between 1100°C and 1200°C is less than 15 seconds.
